# EUROPEAN PATENT APPLICATION

(11) **EP 0 621 005 A1**
(43) Date of publication of application: **26.10.1994**
(21) Application number: 93900342.2
(22) Date of filing: 15.12.1992
(51) Int. Cl.: G01R 33/56

(54) **DATA GATHERING METHOD FOR MR ANGIOGRAPHY**

(30) Priority: 18.12.1991 JP 334839/91
(71) Applicant: YOKOGAWA MEDICAL SYSTEMS, LTD, Hino-shi, Tokyo 191 (JP)
(72) Inventor: YOSHITOME, Eiji, Tachikawa-shi, Tokyo 190 (JP); IKEZAKI, Yoshikazu, Musashino-shi, Tokyo 180 (JP)
(74) Representative: Henkel, Feiler, Hänzel & Partner
(86) International application number: JP9201637
(87) International publication number: WO9311702

(57) **Abstract**

In a data collection method of MR angiography of the invention where scan in warp values of m innumber is carried out in times of the adding average number a per each warp value thereby data of m x a sets are collected, when integer being the closest to the value of {the period T of heartbeat / (the scan repeat time TR x the adding average number)} is made n, the warp values are varied in sequence and continuous scan of n times is carried out, and such scan is repeated by times of the adding average number a and data of n x a sets are collected and this is repeated regarding all warp values thereby data of m x a sets are collected.

## Description

### Technical Field

The present invention relates to a data collection method for MR angiography, and more specifically to a data collection method for MR angiography where even if the adding average number of measured data is selected arbitrarily a good angiography image without motion arch fact can be obtained.

### Background Art

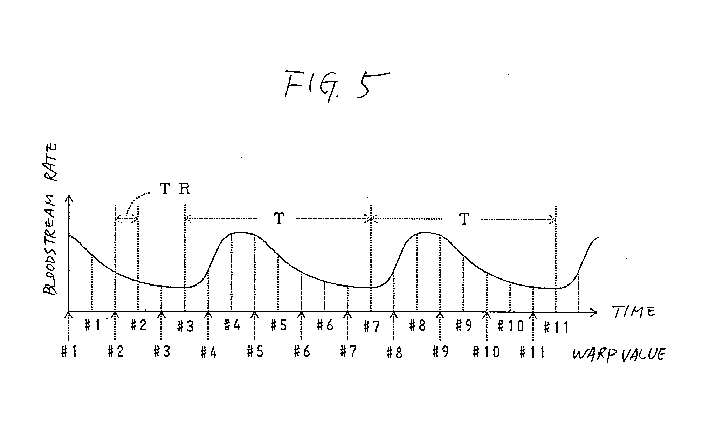

An example of a data collection method for MR angiography in the prior art is shown in Fig. 4. Fig. 4 is an explanation diagram regarding a data collection method of MR angiography proposed by C. Dumoulin et al. in "Rapid Scan Magnetic Resonance Angiography (Mag. Reson. Med. 1987;5:238-45)".

In the data collection method of MR angiography, integer a being the closest to the value of {period T of heartbeat / (scan repeat time TR)} is made the adding average number and scan of the same warp value is repeated by times of the adding average number a and data of the a sets in the same warp value are collected and such scan is repeated regarding the warp value of m steps, thereby data of m x a sets are collected. In Fig. 4, period of updating the warp value is t = TR x a and is nearly equal to the period T of heartbeat.

According to this, since any bloodstream rate in each step of the warp value becomes the average bloodstream rate of one heartbeat and no difference exists between steps, a good angiography image without motion arch fact can be obtained.

In the above-mentioned data collection method of MR angiography in the prior art, the time of t x m is required to collect data of m x a sets. t is nearly equal to the period T of the heartbeat and is about one second. Also the step number is 256 for example. Consequently, in this case, the data collection time becomes about 256 seconds.

If the adding average number a is decreased to 2 of minimum, as shown in Fig. 5, since t becomes t = 2TR, the whole data collection time can be reduced even when the warp step number m is the same. However, since the bloodstream rate in each step of the warp value does not always become the average bloodstream rate of one heartbeat and difference between steps increases, the motion arch fact becomes noticeable.

That is, in the data collection method of MR angiography in the prior art, since the adding average number a must be selected to a value so that product with TR is approximately coincident with one period of the heartbeat, a problem exists in that the adding average number a cannot be selected arbitrarily. Another problem exists in that since the adding average number a becomes a relatively large value, the whole data collection time becomes long.

### Disclosure of Invention

Accordingly, an object of the present invention is to provide a data collection method of MR angiography where the adding average number a can be selected arbitrarily and a good angiography image without motion arch fact can be obtained from a small value of the adding average number a.

The present invention is in a data collection method of MR angiography where scan in the m warp values is carried out in times of the adding average number a per each warp value, thereby data of m x a sets are collected, characterized in that when integer being the closest to the value of {the period T of heartbeat / (the scan repeat time TR x the adding average number an is made n, the warp values are varied in sequence and continuous scan of n times is carried out, and such scan is repeated by times of the adding average number a and data of n x a sets are collected and this is repeated regarding all warp values, thereby data of m x a sets are collected.

In the data collection method of MR angiography, scan regarding warp values corresponding to n steps is repeated by the adding average number a within the time nearly equal to the period T of heartbeat. In other words, scan of the same warp value is carried out in such timing that the period T of the heartbeat is substantially equally divided by the adding average number a.

Consequently, any bloodstream rate in each step of the warp value becomes close to the average bloodstream rate of one heartbeat and difference between steps becomes small. As a result, the value of the adding average number a can be selected arbitrarily. Also although the value of a is small, a good angiography image without motion arch fact can be obtained. Thereby the adding average number a can be decreased and the data collection time can be reduced.

Brief Description of Drawings
Fig. 1 is a block diagram of an MRI apparatus to carry out a data collection method of MR angiography of the invention;
Fig. 2 is a flow chart of an embodiment of a data collection method of MR angiography of the invention;
Fig. 3 is an explanation diagram of scan timing according to a data collection method of MR angiography of the invention; and
Fig. 4 and Fig. 5 are explanation diagrams of scan timing according to a data collection method of MR angiography in the prior art.

### Best Mode for Carrying Out the Invention

The present invention will be described further in detail based on embodiments shown in the accompanying drawings as follows. In this connection, the present invention is not limited by the embodiments.

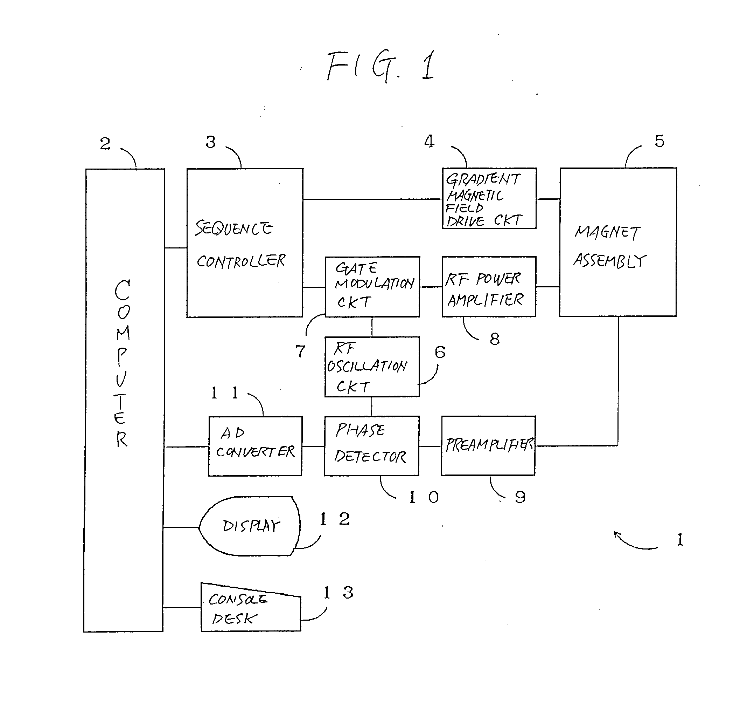

Fig. 1 is a block diagram of an MRI apparatus 1 to carry out a data collection method of MR angiography of the present invention.

A computer 2 controls the whole operation based on command from a console desk 13.

A space of static magnetic field holding a specimen is formed within a magnet assembly 5.

A sequence controller 3 operates a gradient magnetic field drive circuit 4 based on stored sequence, so that a gradient magnetic field is generated in a static magnetic field space by a gradient magnetic field coil within a magnet assembly 5. It also controls a gate modulation circuit 7, so that RF pulse generated by an RF oscillation circuit 6 is modulated into prescribed waveform and applied through an RF power amplifier 8 to a transmission coil within the magnet assembly 5. The transmission coil forms RF rotary magnetic field in the static magnetic field space.

NMR signal from the specimen obtained in a reception coil within the magnet assembly 5 is inputted through a preamplifier 9 to a phase detector 10, and further inputted through an AD converter 11 to the computer 2.

The computer 2 reconstructs image based on data of NMR signal obtained from the AD converter 11, and displays the reconstructed image in a display 12.

A data collection method of MR angiography in an embodiment of the present invention is executed by procedure stored in the computer 2 and the sequence controller 3.

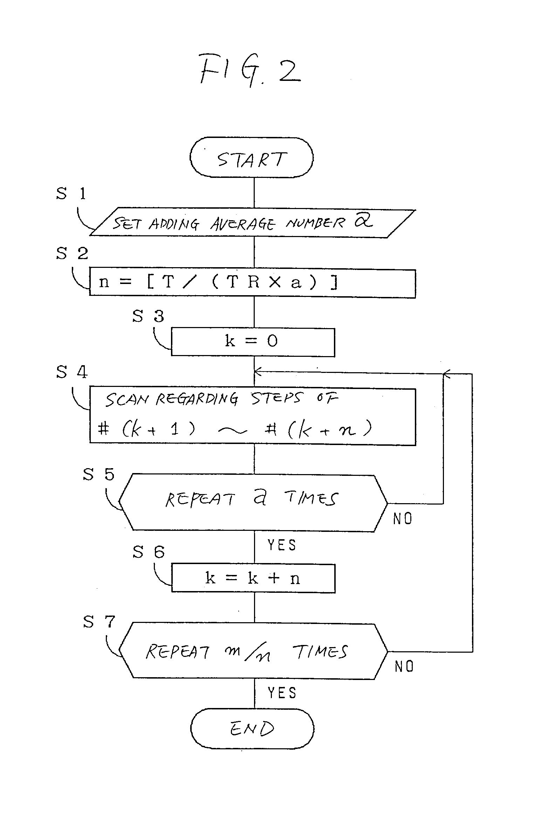

Fig. 2 is a flow chart of a data collection method of MR angiography in an embodiment of the present invention.

In step S1, a user sets the adding average number a arbitrarily by the console desk 13.

In step S2, integer n being the closest to {the period T of heartbeat / (the scan repeat time TR x the adding average number an is calculated. For example, if the period T of heartbeat is one second, the repeat time TR is 1/8 seconds and the adding average number a is 2, n becomes n = 4.

In step S3, the warp step jump value shall be k = 0.

In steps S4, S5, at first, scanning regarding warp steps #1 - #n is repeated in times of a. In this example, scanning regarding steps of #1 - #4 is repeated two times.

In step S6, the warp step jump value shall be k = k + n. At first, k becomes n. For example, k becomes 4.

In step S7, the above-mentioned steps S4 - S6 are repeated in m/n times. For example, if m = 256, the steps are repeated in times of 256/4 = 64.

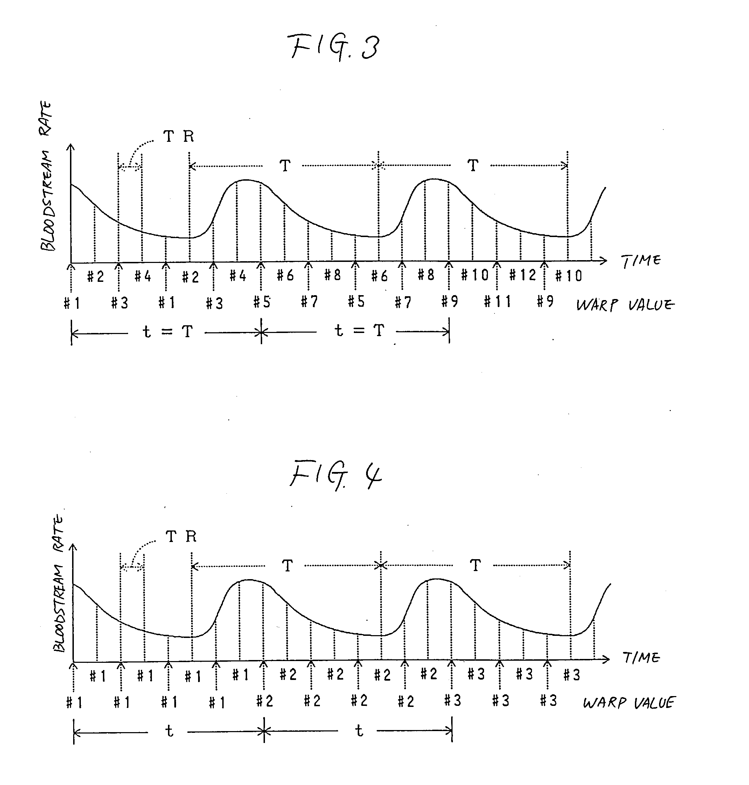

As above described, it follows that scan is carried out in sequence shown in Fig. 3. In Fig. 3, TR = T/8 and a = 2.

As seen from Fig. 3, since scan of the same warp value is carried out in timing so that the period T of the heartbeat is equally divided in a, variation of the bloodstream rate during one period of the heartbeat is canceled by averaging the measured data and the bloodstream rate becomes equivalent to the average bloodstream rate. Since the condition is the same in any step, no difference of the bloodstream rate exists between steps and a good image without motion arch fact can be obtained. Also the data collection time can be reduced by decreasing the adding average number a.

## Claims

1. A data collection method of MR angiography, wherein scan in warp values of m in number is carried out in times of the adding average number a per each warp value thereby data of m x a sets are collected,
characterized in that when integer being the closest to the value of {the period T of heartbeat / (the scan repeat time TR x the adding average number an is made n, the warp values are varied in sequence and continuous scan of n times is carried out, and such scan is repeated by times of the adding average number a and data of n x a sets are collected and this is repeated regarding all warp values thereby data of m x a sets are collected.
